# EUROPEAN PATENT APPLICATION

(11) **EP 1 813 388 A1**
(43) Date of publication of application: **01.08.2007**
(21) Application number: 05765702.5
(22) Date of filing: 13.07.2005
(51) Int. Cl.: B24D 11/00, B24B 9/00, B24B 21/00, B24D 3/00, H01L 21/304

(54) **POLISHING TAPE AND POLISHING METHOD**

(30) Priority: 16.11.2004 JP 2004331407
(71) Applicant: Nihon Microcoating Co., Ltd., Akishima-shi, Tokyo 1960021 (JP)
(72) Inventor: KUMASAKA, Noriyuki, NIHON MICROCOATING CO., LTD, Tokyo, 196-0021 (JP)
(74) Representative: Lerwill, John
(86) International application number: PCT/JP2005/012926
(87) International publication number: WO 2006/054378

(57) **Abstract**

The invention provides a polishing tape and method capable of polishing the edge part of a workpiece to be flat and smooth at a high quality level without causing any contamination to the workpiece by metals. An edge part 21 of a disk-shaped workpiece 20 is polished by pressing a polishing tape 30 and causing a pad 12 or a contact roller 13 to undergo a reciprocating motion intermittently or continuously along the edge part such that the front surface part 22, the end surface part 23 and the back surface part 24 of the workpiece are polished. The polishing tape has a polishing layer formed by having diamond particles with average diameter in the range of 0.1µm - 16µm fastened by a binder. This series of polishing steps may be repeated by using different polishing tapes with diamond particles having different average diameters.

## Description

### Technical Field

This invention relates to a polishing tape and method suited for polishing the edge of a disk-shaped workpiece such as a magnetic disk or a substrate for a semiconductor device.

### Background of the Invention

Aluminum substrates and glass substrates are being used as substrates for magnetic disks. Those made of silicon, sapphire and gallium nitride are being used as substrates for semiconductor devices, and the edge parts of these disk-shaped substrates (hereinafter each referred to as a workpiece) are subjected to a beveling (or chamfering) process.

The beveling process on such a workpiece takes place after the corners of its edge parts are removed by a rough polishing process.

The beveling process is carried out, as described in Reference 1, by tilting the workpiece by a specified angle and pressing the edge of the workpiece against a cylindrical rotary grindstone.

Problems arise with such a method, however, because the surface of the grindstone wears out with the elapse of polishing time, dropping off abrading particles. Such particles may become attached to the workpiece and the surface of the grindstone may become deformed to cause damage to the edge part of the workpiece. In other words, fluctuations result in the edge quality of the workpiece after the polishing, adversely affecting the reproducibility.

For this reason, tape polishing methods are coming to be investigated, as described in Reference 2.

Tape polishing methods are roughly divided into the so-called free-particle polishing and fixed-particle polishing methods. The free-particle polishing method is carried out by pressing a tape (say, of a woven cloth) onto the edge part of the workpiece and causing this tape to advance as polishing slurry having abrading particles dispersed therein is supplied. Thus, the reproducibility of the edge quality of the workpiece after the polishing process has been thereby improved but there remain problems in that the abrading particles tend to remain on the surface of the workpiece and it is troublesome and takes time to wash off the abrading particles that remain after the polishing.

The fixed-particle polishing method is carried out, on the other hand, by pressing a polishing tape having a polishing layer with abrading particles fastened by a binder against the edge part of the workpiece and hence is advantageous in that the time and trouble required for washing off the abrading particles remaining on the surface of the workpiece after the polishing can be dispensed with. Since the polishing tape is appropriately supplied onto the edge part of the workpiece, furthermore, the wears in the polishing layer on the polishing tape can be significantly reduced and the amount of abrading particles that drop off becomes less. Thus, problem of damage to the edge part of the workpiece is obviated, and the reproducibility of the quality of the polishing has improved.

Examples of abrading particles that have conventionally been used for the fixed-particle polishing include particles of one or more kinds selected from materials such as cerium oxide, lanthanum oxide, zirconium oxide, manganese dioxide, aluminum oxide, colloidal silica, iron oxide, silicon carbide and chromium oxide, as well as their mixtures, as disclosed, for example, in Reference 3.
Reference 1: Japanese Patent Publication Tokkai 3-208550
Reference 2: Japanese Patent Publication Tokkai 9-186234
Reference 3: Japanese Patent Publication Tokkai 5-309571

### Disclosure of Invention

### Problems to be solved by the Invention

In the technical field of production of magnetic disks and semiconductor devices, it is coming to be required to polish the edge part of the substrate for a magnetic disk or a semiconductor device (that is, the part from the end surface part on the outer periphery of the workpiece to the area towards its center by several millimeters) to a high quality level such that the recording density of the magnetic disk can be increased and a high-density multi-layer wiring structure of the semiconductor device can be made possible.

Conventional methods of fixed-particle polishing, however, make use of particles comprising materials such as aluminum oxide and silicon carbide or mixed particles containing such materials, including metallic ions. This gives rise to the problem that metals remain on the edge part of a workpiece after the polishing and that the workpiece is contaminated. Thus, a further improvement in quality is being required in the production field of magnetic disks and semiconductor devices.

In the production field of magnetic disks and semiconductor devices, furthermore, it is being required not only that the edge part of a substrate for a magnetic disk or a semiconductor device be polished to a high quality level but also that the polishing be carried out in a shorter time and that the throughput be improved.

It is therefore an object of this invention to provide a polishing tape and method capable of polishing the edge part of a workpiece to be flat and smooth at a high quality level without causing any contamination to the workpiece by metals.

### Means for solving the Problems

In view of the object described above, the present invention relates to a polishing pad and method for polishing the edge part of a disk-shaped workpiece.

A polishing tape according to this invention is characterized as comprising a base film and a polishing layer having diamond particles fastened with a binder, the polishing layer being formed on a surface of the base film.

The diamond particles having an average diameter of 0.1µm - 16µm, the polishing layer containing the diamond particles in an amount of 40 weight % - 80 weight % with respect to the binder.

The base film has a thickness of 8µm - 100µm, a tensile strength of 20kg/mm² or greater, a coefficient of tensile extension of 130% or greater and an edge cracking resistance of 20kg/20mm or greater.

The surface of the polishing layer has average surface roughness of 0.07µm - 2.7µm.

A polishing method of this invention for the edge part of a disk-shaped workpiece comprises the steps of rotating the workpiece, pressing a polishing tape of this invention onto the edge part of the workpiece through a pad or a contact roller, supplying water or a liquid chemical between the edge part of the workpiece and the polishing tape and moving the contact pad or the contact roller intermittently or continuously along the edge part of the workpiece while pressing the polishing tape onto the edge part of the workpiece such that a front surface part, an end surface part and a back surface part of the edge portion of the workpiece are polished. The edge part of the workpiece is thus polished by this series of polishing steps.

This series of polishing steps may be repeated for a plural number of times, the average diameter of diamond particles on the polishing tape used being varied for each series of these polishing steps. The average diameter of diamond particles on the polishing tape used in each series of polishing steps is in the range of 0.1µm - 16µm.

This series of polishing steps is preferably repeated twice. The average diameter of diamond particles on the polishing tape used in the first series of polishing steps is in the range of 5µm - 16µm and that of diamond particles on the second polishing tape used in the second series of polishing steps is in the range of 0.1µm - 5µm.

### Effects of the Invention

With a polishing tape and method of this invention as described above, the edge part of a workpiece can be polished smoothly at a high polishing rate such that the polishing can be effected quickly and at an improved throughput. Since contamination of the workpiece by metals can be obviated, the polishing work can be accomplished at a high quality level and the yield can be improved.

### Best Mode for carrying out the Invention

This invention relates to a polishing tape and method for polishing the edge (that is, the front surface, end surface and back surface parts) of a disk-shaped workpiece such as a substrate for a magnetic disk or a semiconductor device.

### <Polishing Tape>

A polishing tape according to this invention comprises a base film and a polishing layer having diamond particles fastened by a binder, the polishing layer being formed on the surface of the base film.

The diamond particles are monocrystalline or polycrystalline diamond particles with average diameter in the range of 0.1µm - 16µm. If the average diameter of the diamond particles is less than 0.1µm, the polishing rate drops and the throughput is adversely affected. If the average diameter of the diamond particles is greater than 16µm, on the other hand, scratches are formed on the edge of the workpiece or its surface roughness grows large and the quality of the workpiece is adversely affected.

The ratio of the diamond particles with respect to the binder within the polishing layer is in the range of 40 weight % - 80 weight %. If this ratio is less than 40 weight %, the quantity of the binder is too great, and the so-called tacking occurs on the surface of the polishing tape. If the ratio of the diamond particles is greater than 80 weight %, on the other hand, the dispersion characteristic of the diamond particles drops inside the binder when the polishing tape is being produced, and the diamond particles tend to drop off during the polishing process.

Films comprising a material such as polyethylene terephthalate (PET), polyethylene-2,6-naphthalate, polycarbonate, polyamide and polyimide are used as the base film.

Since the polishing tape is pressed against a curved surface of the workpiece for polishing its edge part, the tensile strength of its base film is in the range of 20kg/mm² or greater, its coefficient of tensile extension is in the range of 130% or greater and its edge cracking resistance is in the range of 20kg/20mm or greater.

The thickness of the base film is in the range of 8µm - 100µm. If it is less than 8µm, the required tensile strength of 20kg/mm² or greater cannot be obtained. If it is over 100µm, on the other hand, the ability of the polishing tape to follow the contour of the edge of the workpiece to which it is pressed is adversely affected.

The average surface roughness of the polishing layer is in the range of 0.07µm - 2.7µm. If it is less than 0.07µm, it taken too much time for the polishing. If it is over 2.7µm, the edge part of a workpiece cannot be polished smoothly.

### <Production of the Polishing Tape>

In order to produce a polishing tape of the present invention, a binder is mixed with diamond particles. As described above, the diamond particles are mixed at a rate of 40 weight % - 80 weight %. After this mixture is diluted with an organic solvent, it is stirred to produce a polishing paint.

A binder of polyester or urethane type is used. Its glass transition temperature (Tg) is in the range of 1°C - 80°C. Examples of organic solvent include ketones such as acetone, methyl ethyl ketone and methyl isobutyl ketone; alcohols such as methanol, ethanol and butanol; esters such as methyl acetate, ethyl acetate and butyl acetate; and ethers. The dispersion characteristic of the diamond particles and the viscosity of the polishing paint are adjusted by adding an appropriate amount of this organic solvent to the mixture described above. The viscosity of the polishing paint is adjusted to be in the range of 50cp - 300cp.

Next, the diamond particles inside the polishing paint are dispersed. If the average diameter of the diamond particles is 3µm or greater (that is, in the range of 3µm - 16µm), the secondary diamond particles (aggregates) in the polishing paint are decomposed by ultrasonic waves to reduce them into the form of primary particles to disperse them. The time taken for the dispersing is in the range of 30 minutes - 3 hours.

If the average diameter of the diamond particles is less than 3µm (that is, in the range of 0.1µm - 3µm), a ball mill is used to disperse the diamond particles inside the polishing paint. When a ball mill is used, diamond particles, a binder and an organic solvent are placed inside a pot, and the pot is rotated to decompose the secondary particles into the form of primary particles and to disperse them in the polishing paint. The time taken for the dispersion is in the range of 12 hours - 250 hours.

Next, the polishing paint with the diamond particles dispersed therein is passed through a filter to remove the foreign objects such as impurities, debris and aggregated particles which have failed to have been dispersed. A filter with mesh size in the range of 0.5µm - 125µm is used.

Next, the surface of the base film is coated with this polishing paint. A known coating technology such as gravure coating, reverse coating, reverse gravure coating and dye coating may be used for this coating process. The polishing paint is coated onto the base film such that its thickness will be in the range of 4µm - 15µm.

After this polishing paint thus applied onto the surface of the base film is dried at a temperature in the range of 90°C - 130°C, it is cured for a period of 3 days or longer at 40°C. A polishing tape according to this invention is thus produced.

### <Polishing Method>

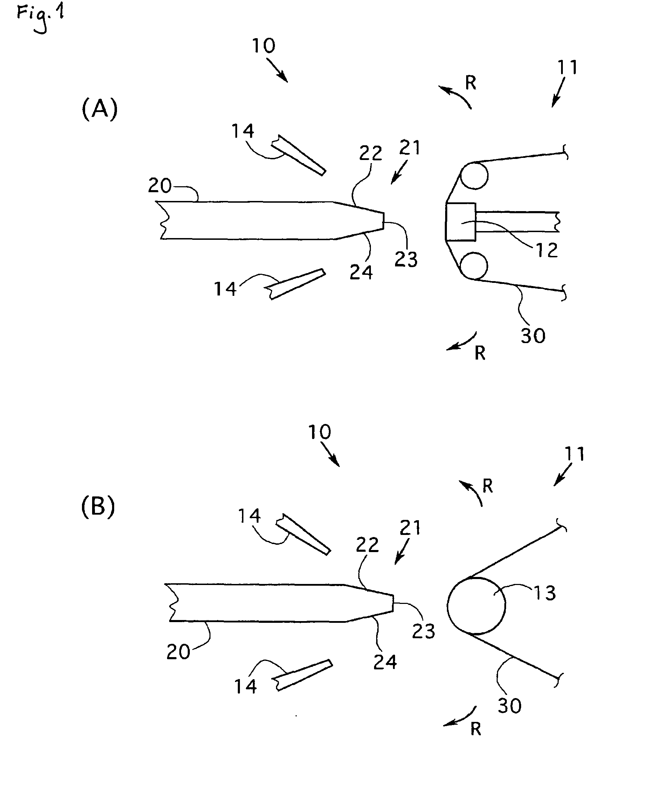

A polishing method of this invention is described next with reference to Fig. 1A which shows a polishing machine 10 (such as described in Japanese Patent 2837342) for polishing an edge part 21 of a disk-shaped workpiece 20. This edge part 21 is assumed to have already been subjected to a preliminary polishing process whereby the corners of the edges of the workpiece is removed by using a grindstone of a conventionally known type made of a material such as diamond and silicon carbide.

As shown in Fig. 1A, the polishing machine 10 comprises a spindle (not shown) for attaching a workpiece 20 and to be rotated and a polishing head 11 for pressing a polishing tape 30 onto the edge 21 of the workpiece 20 mounted to the spindle. The polishing tape 30 is pressed onto the edge 21 of the workpiece 20 through a pad 12 of an elastic material provided to the polishing head 11. The polishing tape 30 is supplied from a supply roller (not shown) provided either externally or to the polishing head 11, passed on the pad 12 and taken up by a take-up roller (not shown) provided either externally or to the polishing head 11. The polishing head 11 1 is adapted to undergo an intermittent or continuous reciprocating motion (in the direction indicated by arrow R) along the edge 21 of the workpiece 20 while pressing the polishing tape 30 through the pad 12 onto the edge 21 of the workpiece 20. The polishing head 11 is also adapted to undergo a reciprocating motion (or to oscillate) in the direction of rotation of the workpiece 20 while pressing the polishing tape 30 through the pad 12 onto the edge 21 of the workpiece 20. These reciprocating motions of the polishing head 11 can be effected by a mechanism (not shown) of a known kind.

When the edge 21 of the disk-shaped workpiece 20 is polished, the workpiece 20 is first attached to the spindle (not shown) and then rotated. While the polishing tape 30 is supplied past the pad 12, the polishing tape 12 is pressed onto the edge 21 of the workpiece 20 through the pad 12. In this manner, the polishing tape 30 is pressed onto the front surface part 22, the end surface part 23 or the back surface part 24 of the edge 21. In the meantime, water or a liquid chemical is supplied to the space between the edge 21 of the workpiece 20 and the polishing tape 30 through nozzles 14 that are directed towards the front surface part 22 and the back surface part 24 of the edge 21.

Although Fig. 1A shows an example wherein the polishing tape 30 is pressed to the edge 21 of the workpiece 20 through the pad 12, a contact roller 13 of a known type may be used instead of the pad 12, as shown in Fig. 1B.

Examples of the liquid chemical to be used when the edge 21 of the workpiece 20 comprises silicon dioxide include potassium hydroxide, tetramethyl ammonium hydroxide, fluoric acid and fluorides. If the edge 21 1 of the workpiece 20 comprises tungsten, iron nitrate and potassium iodate may be used. If the edge 21 of the workpiece 20 comprises copper, glycine, quinaldinic acid, hydrogen peroxide and benzotriazol may be used.

The front surface part 22, the end surface part 23 and the back surface part 24 of the edge 21 of the workpiece 20 are polished by causing the pad 12 (or the contact roller 13) to undergo a reciprocating motion along the edge 21 of the workpiece 20 either intermittently (by momentarily stopping on the front surface part 22, the end surface part 23 and the back surface part 24) or continuously while the polishing tape 30 is kept pressed against the edge 21 of the workpiece 20. As a result, the edge 21 of the workpiece 20 is polished in a rounded curved shaped of the surface. In the above, the polishing head 11 may be caused to undergo a reciprocating motion in the direction of rotation of the workpiece 20 while the polishing tape 30 is pressed against the edge 21 of the workpiece 20 and the pad 12 (or the contact roller 13) undergoing a reciprocating motion along the edge 21 of the workpiece 20. In this manner, the edge 21 of the workpiece 20 can be polished even more smoothly.

According to this invention, the edge 21 of the workpiece 20 can be polished by a series of polishing processes as described above.

According to this invention, the series of polishing processes as described above many be repeated any number of times, instead of just once, depending on the kind of the workpiece 20. Explained more in detail, smoothness of the edge 21 of the workpiece 20 can be gradually improved (or its average surface roughness can be made smaller) by varying the average particle size of the diamond particles of the polishing tape 30 used in each of a plurality of polishing processes.

For example, the edge 21 may be polished by using diamond particles with average particle size of 9µm - 16µm in the first polishing process such that the average surface roughness becomes 50nm - 90nm, using diamond particles with average particle size of 3µm - 5µm in the second polishing process such that the average surface roughness becomes 20nm - 40nm, and finally using diamond particles with average particle size of 0.1µm - 0.5µm in the third polishing process such that the average surface roughness becomes 0.4nm - 0.6nm.

In other words, the polishing processes may be carried out sequentially as explained above, depending on the initial (average) surface roughness of the workpiece. The first polishing process and the second polishing process alone may be carried in this order, or the third polishing process may be carried out after the first polishing process. Alternatively, the second polishing process alone may be carried out.

### <Test Example 1>

A polishing tape of Test Example 1 was produced as follows.

A binder comprising polyester resin and monocrystalline diamond particles with average diameter 9µm (granularity #2000) were mixed at a rate of 60 weight % of diamond particles with respect to the binder, and an appropriate amount of an organic solvent was added to it. This is subjected to ultrasonic vibrations for 30 minutes to decompose agglomerated particles. This mixture was then passed through a filter to remove impurities, debris and aggregated particles to produce a polishing paint with viscosity about 100 - 150cp.

Next, the surface of a base film of polyethylene terephthalate (PET) with thickness 50µm was coated with the aforementioned polishing paint by reverse gravure process to a thickness of 8µm. After this polishing paint was dried, it was cured for 3 days at 40°C and slit to the width of 76.2mm (3 inches) to produce a polishing tape of Test Example 1. The surface roughness of this polishing tape was 1.5µm.

### <Test Example 2>

A polishing tape of Test Example 2 was produced similarly as explained above for Test Example 1 except that the average diameter of diamond particles was 5µm (granularity #3000) and that the polishing paint was coated on the surface of the base film to the thickness of 6µm. The surface roughness of this polishing tape was 1.2µm.

### <Test Example 3>

A polishing tape of Test Example 3 was produced similarly as explained above for Test Example 1 except that the average diameter of diamond particles was 3µm (granularity #4000) and that the polishing paint was coated on the surface of the base film to the thickness of 5µm. The surface roughness of this polishing tape was 0.9µm.

### <Test Example 4>

A polishing tape of Test Example 4 was produced similarly as explained above for Test Example 1 except that the average diameter of diamond particles was 0.5µm (granularity #10000), that a ball mill was used for mixing and dispersing for 250 hours instead of ultrasonic waves, and that the polishing paint was coated on the surface of the base film to the thickness of 6µm. The surface roughness of this polishing tape was 0.12µm.

### <Comparison Example 1>

A polishing tape of Comparison Example 1 was produced similarly as explained above for Test Example 1 except that silicon carbide particles with average diameter of 3µm (granularity #4000) were used, and that the polishing paint was coated on the surface of the base film to the thickness of 17µm. The surface roughness of this polishing tape was 0.6µm.

### <Comparison Example 2>

A polishing tape of Comparison Example 2 was produced similarly as explained above for Test Example 1 except that alumina (Al₂O₃) particles with average diameter of 3µm (granularity #4000) were used, and that the polishing paint was coated on the surface of the base film to the thickness of 16µm. The surface roughness of this polishing tape was 1.55µm.

### <Comparison Example 3>

A polishing tape of Comparison Example 3 was produced similarly as explained above for Test Example 1 except that a mixture of silicon carbide particles and alumina particles (with mixing ratio of 1 weight %/1 weight %) with average diameter of 3µm (granularity #4000) was used, and that the polishing paint was coated on the surface of the base film to the thickness of 5µm. The surface roughness of this polishing tape was 0.9µm.

### <Polishing Test 1>

Each of the polishing tapes of Test Examples 1-4 and Comparison Examples 1-3 was used to polish the edge of an 8-inch silicon substrate for a semiconductor device preliminarily having a rough polishing process carried out. The polishing rate and the average surface roughness (Ra) were measured, and the remnant metal particles on the edge were observed.

The average surface roughness of the edge of the silicon substrates before the polishing was 0.1µm. The polishing was carried out by a polishing machine as shown in Fig. 1. The conditions of the polishing were as shown in Table 1 below.

### [Table 1]

**Table 1**

| | |
|---|---|
| Rotational speed of spindle | 500 rpm |
| Feed speed of tape | 10 mm/min |
| Compressive pressure of tape | 12N |

(Polishing Test 1-A) Polishing tape of Test Example 1 was used for 5 minutes.

(Polishing Test 1-B) Polishing tape of Test Example 2 was used for 5 minutes.

(Polishing Test 1-C) Polishing tape of Test Example 3 was used for 5 minutes.

(Polishing Test I-D) Polishing tape of Test Example 1 was used for 2 minutes for first polishing and thereafter polishing tape of Test Example 3 was used for 3 minutes for second polishing.

(Polishing Test 1-E) Polishing tape of Test Example 2 was used for 2 minutes for first polishing and thereafter polishing tape of Test Example 4 was used for 3 minutes for second polishing.

(Polishing Test 1-F) Polishing tape of Comparison Example 1 was used for 5 minutes.

(Polishing Test 1-G) Polishing tape of Comparison Example 2 was used for 5 minutes.

(Polishing Test 1-H) Polishing tape of Comparison Example 3 was used for 5 minutes.

### <Test Results 1>

Results of Polishing Test 1 are shown in Table 2. The polishing rate indicates the difference in weight between before and after the polishing. The average surface roughness is the measured value by a scanning-type white-light interferometer. Presence (YES) and absence (NO) of remnant metals (or the contamination of the edge by remnant metals) was observed by using a scanning-type X-ray microanalyzer.

### [Table 2]

**Table 2**

| Polishing Test No. | Polishing rate (mg/min) | Average surface roughness (Ra) (nm) | Remnant metals |
|---|---|---|---|
| 1-A (Test Example 1) | 618.6 | 45.3 | NO |
| 1-B (Test Example 2) | 178.1 | 29.5 | NO |
| 1-C (Test Example 3) | 114.4 | 21.0 | NO |
| 1-D (Test Examples 1, 3) | 388.5 | 14.2 | NO |
| 1-E (Test Examples 2,4) | 96.9 | 0.5 | NO |
| 1-F (Comparison Example 1) | 6.7 | 13.7 | YES |
| 1-G (Comparison Example 2) | 7.4 | 26.1 | YES |
| 1-H (Comparison Example 3) | 25.6 | 25.2 | YES |

Table 2 shows that if a polishing tape according to this invention is used for polishing the edge of a silicon substrate for a semiconductor device, the polishing can be effected at a significantly higher polishing rate to make the edge smooth without causing metals to remain on the edge after the polishing and to thereby contaminate the substrate. The edge can be made particularly smooth if two kinds of tapes according to this invention are used as in Polishing Tests 1-D and 1-E to carry out the polishing process twice.

### <Polishing Test 2>

Each of the polishing tapes of Test Examples 1-4 and Comparison Examples 1-3 was used to polish the edge of a 4.5-inch glass substrate for a magnetic hard disk preliminarily having a rough polishing process carried out. The polishing rate and the average surface roughness (Ra) were measured, and the remnant metal particles on the edge were observed.

The average surface roughness of the edge of the glass substrates before the polishing was 0.1µm. The polishing was carried out by a polishing machine as shown in Fig. 1. The conditions of the polishing were as shown in Table 1 above.

(Polishing Test 2-A) Polishing tape of Test Example 3 was used for 5 minutes.

(Polishing Test 2-B) Polishing tape of Test Example 1 was used for 2 minutes for first polishing and thereafter polishing tape of Test Example 3 was used for 3 minutes for second polishing.

(Polishing Test 2-C) Polishing tape of Test Example 2 was used for 2 minutes for first polishing and thereafter polishing tape of Test Example 4 was used for 3 minutes for second polishing.

(Polishing Test 2-D) Polishing tape of Comparison Example 1 was used for 5 minutes.

(Polishing Test 2-E) Polishing tape of Comparison Example 2 was used for 5 minutes.

(Polishing Test 2-F) Polishing tape of Comparison Example 3 was used for 5 minutes.

### <Test Results 2>

Results of Polishing Test 2 are shown in Table 3. As in Table 2, the polishing rate indicates the difference in weight between before and after the polishing. The average surface roughness is the measured value by a scanning-type white-light interferometer. Presence (YES) and absence (NO) of remnant metals (or the contamination of the edge by remnant metals) was observed by using a scanning-type X-ray microanalyzer.

### [Table 3]

**Table 3**

| Polishing Test No. | Polishing rate (mg/min) | Average surface roughness (Ra) (nm) | Remnant metals |
|---|---|---|---|
| 2-A (Test Example 3) | 185.6 | 34.5 | NO |
| 2-B (Test Examples 1, 3) | 425.5 | 22.7 | NO |
| 2-C (Test Examples 2,4) | 113.6 | 10.1 | NO |
| 2-D (Comparison Example 1) | 10.2 | 21.6 | YES |
| 2-E (Comparison Example 2) | 11.9 | 19.7 | YES |
| 2-F (Comparison Example 3) | 85.1 | 36.4 | YES |

Table 3 shows that if a polishing tape according to this invention is used for polishing the edge of a glass substrate for a magnetic hard disk, the polishing can be effected at a significantly higher polishing rate to make the edge smooth without causing metals to remain on the edge after the polishing and to thereby contaminate the substrate. The edge can be made particularly smooth if two kinds of tapes according to this invention are used as in Polishing Tests 2-B and 2-C to carry out the polishing process twice.

### Applicability

Examples have been shown for the polishing the edge of silicon substrates for a semiconductor device and glass substrates for a magnetic hard disk, but the present invention is applicable also to the removal of unwanted protrusions from the edge, the elimination of unwanted films from a semiconductor device or the polishing of the edge of a reproduction wafer. If the average diameter of diamond particles on the polishing tape and the average surface roughness of the polishing tape are appropriately selected, furthermore, the present invention is also applicable to the polishing of the edge of a disk-shaped workpiece made of a material such as sapphire, GaN and SiC.

### Brief Description of the Drawings

[Fig.1] Figs. 1A and 1B, together referred to as Fig. 1, each show a polishing machine that may be used for carrying out the present invention.

### Numerals

- 10: a polishing machine
- 11: a polishing head
- 12: a pad
- 13: a contact roller
- 14: a nozzle
- 20: a disk-shaped workpiece
- 21: an edge part
- 22: a front surface part
- 23: an end surface part
- 24: a back surface part
- 30: a polishing tape
- R: the direction of reciprocating motion

## Claims

1. A polishing tape for polishing an edge part of a disk-shaped workpiece, said polishing tape comprising a base film and a polishing layer having diamond particles fastened with a binder, said polishing layer being formed on a surface of said base film, said diamond particles having an average diameter of 0.1µm - 16µm, said polishing layer containing said diamond particles in an amount of 40 weight % - 80 weight % with respect to said binder.

2. The polishing tape of claim 1 wherein said base film has a thickness of 8µm - 100µm, a tensile strength of 20kg/mm² or greater, a coefficient of tensile extension of 130% or greater and an edge cracking resistance of 20kg/20mm or greater.

3. The polishing tape of claim 1 wherein the surface of said polishing layer has average surface roughness of 0.07µm - 2.7µm.

4. The polishing tape of claim 1 wherein said diamond particles have an average diameter of 5µm - 16µm.

5. The polishing tape of claim 1 wherein said diamond particles have an average diameter of 0.1µm - 5µm.

6. A method of polishing an edge part of a disk-shaped workpiece, said method comprising the steps of:
rotating said workpiece;
pressing a polishing tape onto said edge part of said workpiece through a pad or a contact roller;
supplying water or a liquid chemical between said edge part of said workpiece and said polishing tape; and
moving said contact pad or said contact roller intermittently or continuously along said edge part of said workpiece while pressing said polishing tape onto said edge part of said workpiece such that a front surface part, an end surface part and a back surface part of said edge portion of said workpiece are polished;
wherein said polishing tape comprises a base film and a polishing layer having diamond particles fastened with a binder, said polishing layer being formed on a surface of said base film, said diamond particles having an average diameter of 0.1µm - 16µm, said polishing layer containing said diamond particles in an amount of 40 weight % - 80 weight % with respect to said binder.

7. The method of claim 6 wherein said base film has a thickness of 8um - 100µm, a tensile strength of 20kg/mm² or greater, a coefficient of tensile extension of 130% or greater and an edge cracking resistance of 20kg/20mm or greater.

8. The method of claim 6 wherein the surface of said polishing layer has average surface roughness of 0.07µm - 2.7µm.

9. The method of claim 6 wherein said diamond particles have an average diameter of 5µm - 16µm, said method further comprising the steps of:
pressing a second polishing tape onto said edge part of said workpiece through a pad or a contact roller;
supplying water or a liquid chemical between said edge part of said workpiece and said polishing tape; and
moving said contact pad or said contact roller intermittently or continuously along said edge part of said workpiece while pressing said second polishing tape onto said edge part of said workpiece such that a front surface part, an end surface part and a back surface part of said edge portion of said workpiece are polished;
wherein said second polishing tape comprises a base film and a polishing layer having diamond particles fastened with a binder, said polishing layer being formed on a surface of said base film, said diamond particles having an average diameter of 0.1µm - 5µm, said polishing layer containing said diamond particles in an amount of 40 weight % - 80 weight % with respect to said binder.

10. The method of claim 9 wherein the base film of said second polishing tape has a thickness of 8µm - 100µm, a tensile strength of 20kg/mm² or greater, a coefficient of tensile extension of 130% or greater and an edge cracking resistance of 20kg/20mm or greater.

11. The method of claim 9 wherein the surface of the polishing layer of said second polishing tape has average surface roughness of 0.07µm - 2.7µm.

12. The method of claim 6 comprising a plurality of polishing steps each using a different polishing tape having diamond particles with a different average diameter.
